# EUROPEAN PATENT APPLICATION

(11) **EP 3 955 461 A1**
(43) Date of publication of application: **16.02.2022**
(21) Application number: 20190326.7
(22) Date of filing: 10.08.2020
(51) Int. Cl.: H03H 1/00, H03H 7/06, H02M 1/12, H02M 1/44, H03H 7/42, H03H 7/01

(54) **NOTCH FILTER WITH FREQUNECY DEPENDENT RESISTANCE AND ELECTRICAL SYSTEM COMPRISING SUCH NOTCH FILTER**

(71) Applicant: Valeo Siemens eAutomotive Norway AS, 3036 Drammen (NO)
(72) Inventor: Sørsdahl, Torbjørn, 3036 Drammen (NO)
(74) Representative: Gevers & Orès

(57) **Abstract**

The EMC notch filter (404,1304) comprises a notch inductance (L_{N},L_{LC} ) and a notch capacitance (C2 _{π} ,C_{N}) defining a notch resonance frequency. The notch filter (404,1304) further comprises an attenuation control resistance (R _{N} ) in parallel with the notch inductance if the notch inductance and the notch capacitance are in series or in series with the notch capacitance if the notch inductance and the notch capacitance are in parallel. The attenuation control resistance is intended to be frequency dependent in a manner to allow suppression of power line harmonics with decreasing amplitude.

## Description

The present invention relates to a notch filter, as well as a filter and an electrical system comprising such a notch filter.

It is known to use a notch filter comprising a notch inductance and a notch capacitance defining a notch resonance frequency.

Such prior art notch filter has an attenuation comprising a notch (i.e. a quick increase of the attenuation) around the notch resonance frequency and that goes near zero away from the notch resonance frequency.

A goal of the invention is to propose a notch filter allowing to control the attenuation.

An object of the invention is therefore a notch filter comprising a notch inductance and a notch capacitance defining a notch resonance frequency, characterized in that it further comprises an attenuation control resistance in parallel with the notch inductance if the notch inductance and the notch capacitance are in series or in series with the notch capacitance if the notch inductance and the notch capacitance are in parallel.

Thanks to the invention, the value of the attenuation control resistance allows to control the attenuation above the notch resonance frequency.

Optionally, the notch resistance is a frequency dependent resistance.

Optionally, the notch inductance and the notch capacitance are in series, and the attenuation control resistance is in parallel with the notch inductance.

Optionally, the attenuation control resistance has a resistance value that decreases with frequency starting from the notch frequency.

Optionally, it further comprises a capacitance in parallel with the notch inductance and the attenuation control resistance.

Optionally, it further comprises a capacitance in series with the attenuation control resistance.

Optionally, the notch inductance and the notch capacitance are in parallel, and the attenuation control resistance is in series with the notch capacitance.

Optionally, the attenuation control resistance has a resistance value that increases with frequency starting from the notch frequency.

Optionally, it further comprises an inductance in series with the notch capacitance and the attenuation control resistance.

Optionally, the attenuation control resistance has a resistance value that increases with frequency until at least a frequency greater than the notch resonance frequency.

Another object of the invention is a filter comprising:
- a low-pass filter; and
- a notch filter according to the invention, wherein one amongst the notch inductance and the notch capacitance is also part of the low-pass filter.

Another object of the invention is an electrical system comprising:
- a power source;
- a load; and
- a notch filter according to the invention or a filter according to the invention, through which the load is connected to the power source.

The invention will be better understood using the description which follows, given solely by way of example and made with reference to the appended drawings in which:
[Fig. 1] figure 1 is a circuit diagram of an electrical system comprising an electromagnetic compatibility filter according to prior art,
[Fig. 2] figure 2 is a circuit diagram of an electrical system comprising an electromagnetic compatibility filter according to prior art,
[Fig. 3] figure 3 is a frequency analysis comparing the attenuation of the electrical systems of figures 1 and 2,
[Fig. 4] figure 4 is a circuit diagram of an electrical system comprising an electromagnetic compatibility filter according to a first embodiment of the invention,
[Fig. 5] figure 5 is a frequency analysis comparing the attenuation of the electrical systems of figures 2 and 4,
[Fig. 6] figure 6 is a circuit diagram of an electrical system comprising an electromagnetic compatibility filter according to a second embodiment of the invention,
[Fig. 7] figure 7 is a frequency analysis comparing the attenuation of the electrical systems of figures 4 and 6,
[Fig. 8] figure 8 is a circuit diagram of an electrical system comprising an electromagnetic compatibility filter according to a third embodiment of the invention,
[Fig. 9] figure 9 is a frequency analysis comparing the attenuation of the electrical systems of figures 6 and 8,
[Fig. 10] figure 10 is a circuit diagram of an electrical system comprising an electromagnetic compatibility filter according to a fourth embodiment of the invention,
[Fig. 11] figure 11 is graph illustrating the variation of resistance with frequency of a frequency dependent resistance,
[Fig. 12] figure 12 is a circuit diagram of an electrical system comprising an electromagnetic compatibility filter according to prior art,
[Fig. 13] figure 13 is a circuit diagram of an electrical system comprising an electromagnetic compatibility filter according to a fifth embodiment of the invention,
[Fig. 14] figure 14 is a circuit diagram of an electrical system comprising an electromagnetic compatibility filter according to a sixth embodiment of the invention,
[Fig. 15] figure 15 is a frequency analysis comparing the attenuation of the electrical systems of figures 12, 13 and 14,
[Fig. 16] figure 16 is a circuit diagram of an electrical system comprising an electromagnetic compatibility filter according to a seventh embodiment of the invention, and
[Fig. 17] figure 17 is a frequency analysis comparing the attenuation of different configurations of the electrical system of figure 16.

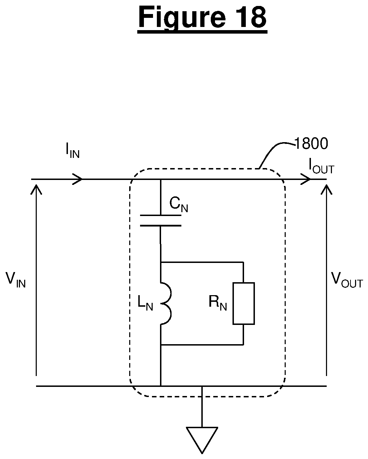

Referring to **figure 18**, a notch filter 1800 according to the invention will now be described.

Notch filter 1800 comprises a notch inductance L_{N} and a notch capacitance C_{N} in series defining a notch resonance frequency. Notch filter 1800 further comprises an attenuation control resistance R_{N} in parallel with notch inductance L_{N}.

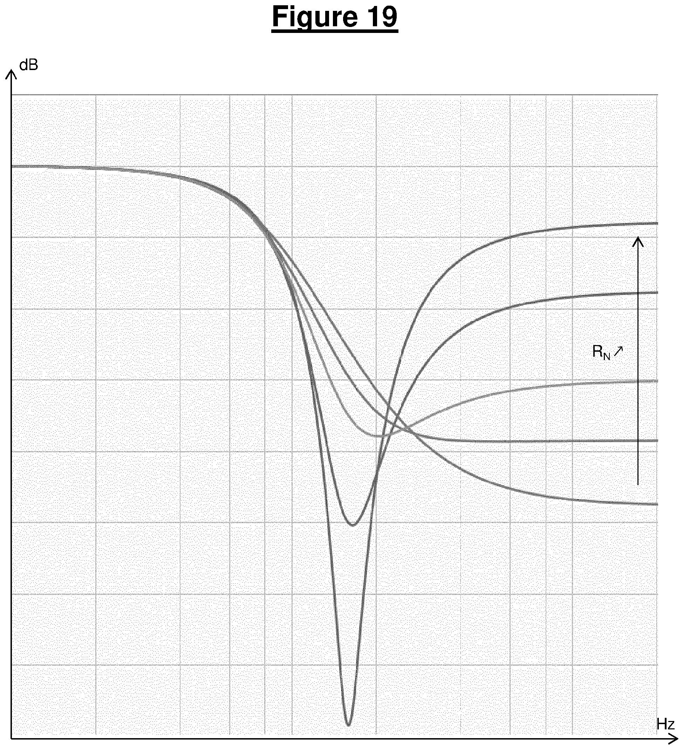

Referring to **figure 19**, attenuation with respect to the frequency for notch filter 1800 is illustrated, as attenuation control resistance R_{N} increases.

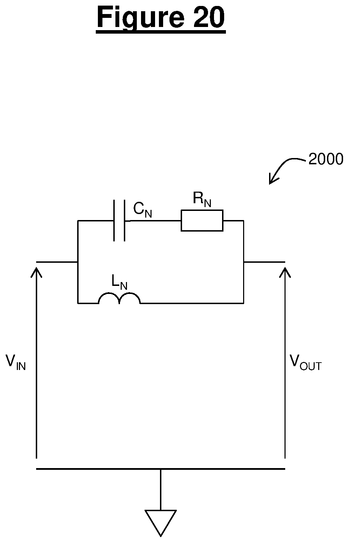

Referring to **figure 20**, a notch filter 2000 according to the invention will now be described.

Notch filter 2000 comprises a notch inductance L_{N} and a notch capacitance C_{N} in parallel defining a notch resonance frequency. Notch filter 2000 further comprises an attenuation control resistance R_{N} in series with notch capacitance C_{N}.

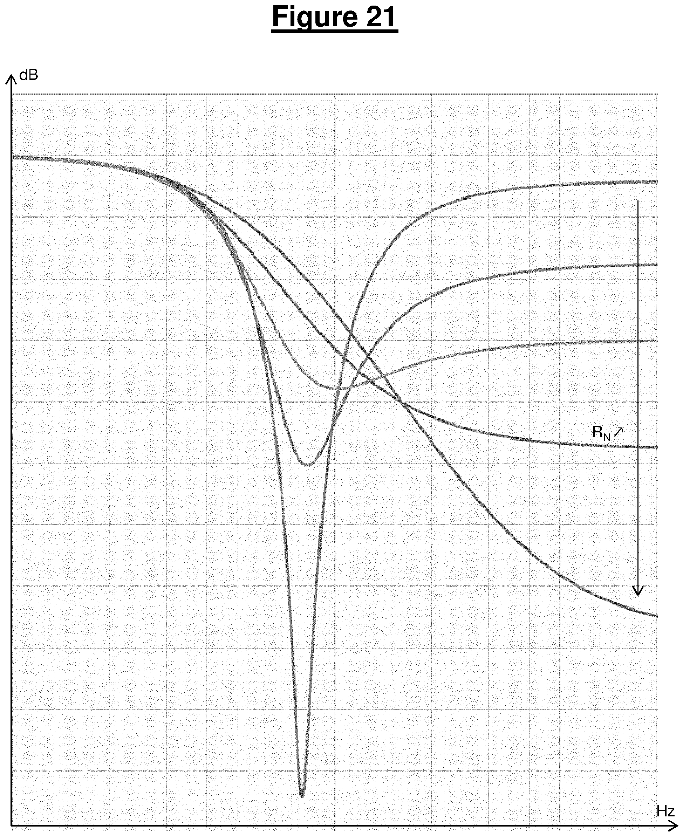

Referring to **figure 21**, attenuation with respect to the frequency for notch filter 2000 is illustrated, as attenuation control resistance R_{N} increases.

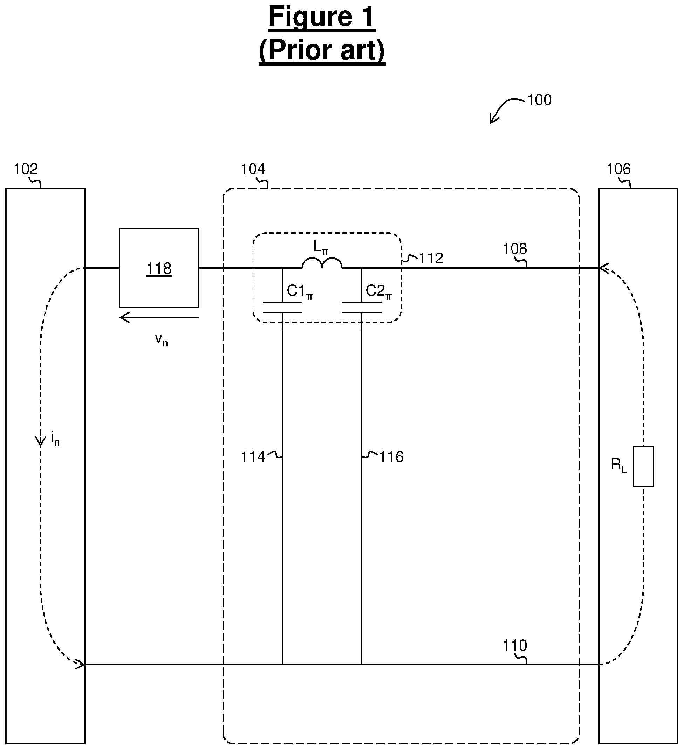

Referring to **figure 1**, an example 100 of electrical system according to prior art will now be described.

In this example, electrical system 100 comprises a DC power source 102, an electromagnetic compatibility (EMC) filter 104 and a load 106 connected to DC power source 102 through EMC filter 104. Load 106 represents for example an electronic equipment and exhibits a load resistance R_{L}. More precisely, electrical system 100 comprises first and second power electrical branches 108, 110 connecting together DC power source 102 to load 106. First power electrical branch 108 usually has a high potential and conveys current to load 106, while second power electrical branch 110 has a low potential and conveys current back to DC power source 102. Second power electrical branch 110 may be connected to a ground of electrical system 100.

In other examples, the power source 102 could be an AC power source.

Preferably, in the described example, the electrical system 100 is a "high power" electrical system, which means for example that the current between DC power source 102 and load 106 exceeds 1 A. In particular, electrical components placed on the first power electrical branch 108 must be designed for this level of current.

EMC filter 104 comprises a pi filter 112, which is a low-pass filter having a cutoff frequency F_{LP} (i.e. a low-pass resonance frequency). Pi filter 108 comprises a first shunt capacitance C1_{π} located on a first shunt branch 114 connecting together power electrical branches 108, 110 and being in parallel with DC power source 102. Pi filter 108 further comprises a second shunt capacitance C2_{π} located on a second shunt branch 116 also connecting together power electrical branches 108, 110 and being in parallel with load 106. Pi filter 108 further comprises a series inductance L_{π} located on first power electrical branch 108, between the two shunt electrical branches 114, 116.

Voltage noise vₙ caused by a noise source 118 such as power electronics, switched circuits or other circuits generating unwanted voltage ripples across branches 108, 110, may appear in electrical system 100. This noise voltage vₙ leads in turn to a noise current iₙ circulating in power electrical branches 108, 110, between DC power source 102 and load 106. If noise voltage vₙ is too high, the electronic equipment represented by load 106 may malfunction.

EMC filter 104 is designed for filtering noise voltage vₙ. This noise voltage vₙ comprises, in the frequency domain, several harmonics. In the case of differential mode noise, these harmonics have rapidly decreasing amplitudes after the first harmonic. In the case of common mode noise, the first harmonics have essentially constant amplitudes (equal to the amplitude of the first harmonic) and the following harmonics have decreasing amplitudes. The decreasing is due to the fact that the frequency either starts to be impacted by load 106 or to get close to the rise time of the noise source. Therefore, if the emission requirements are constant, EMC filter 104 is designed to provide a required attenuation at a required frequency generally taken equal to the first harmonic frequency, and above this required frequency.

The higher is the required attenuation T, the lower is the needed cutoff frequency F_{PL}. For getting a low cutoff frequency F_{PL}, inductance L_{π} and capacitances C1_{π}, C2_{π} need to have high value, which increases their size. Furthermore, inductance L_{π} has to transfer low frequency and DC signal.

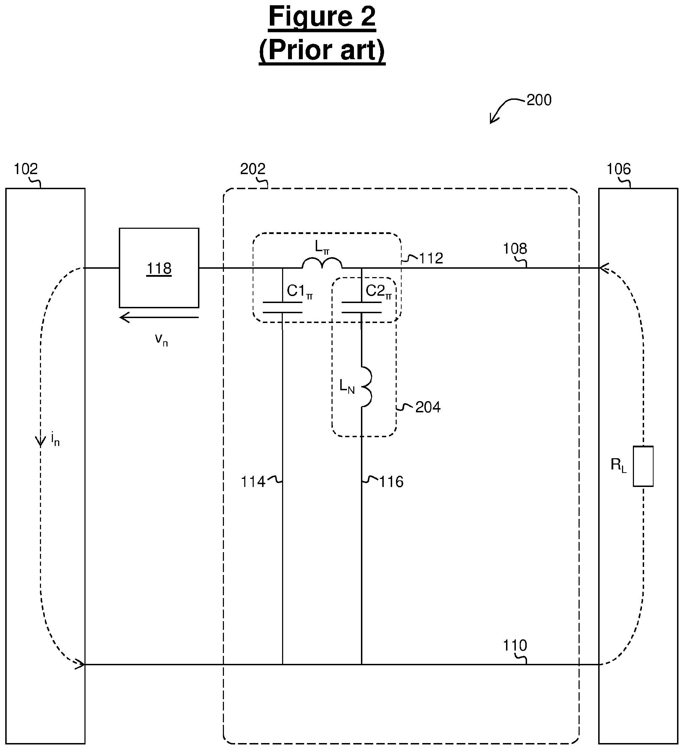

Referring to **figure 2**, an electrical system 200 according to prior art will now be described.

Electrical system 200 is similar to electrical system 100, except for the EMC filter, now referenced 202. EMC filter 202 comprises the pi filter 112 of figure 1 and a notch filter 204. In the described example, notch filter 204 comprises capacitance C2_{π} of pi filter 112 and, in addition, a notch inductance L_{N} located on second shunt branch 116, in series with capacitance C2_{π}.

In the described example, the notch filter 204 has a notch resonance frequency F_{N} higher than low-pass frequency F_{LP}.

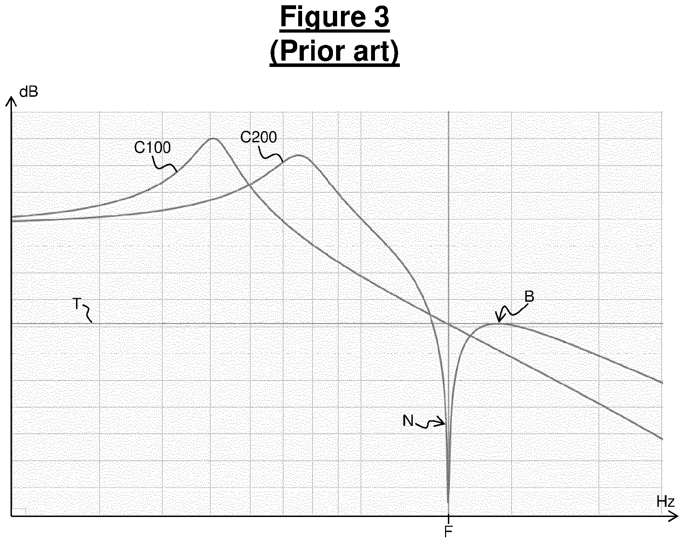

Referring to **figure 3**, as an example, attenuation below a threshold T for frequencies above a frequency F (150 kHz in the illustrated example) is sought.

Curve C100 illustrates the attenuation with respect to the frequency for electrical system 100. The values of the electrical components are: C1_{π} = C2_{π} = 10 nF and L_{π} = 1 mH. As illustrated, curve C100 passes below threshold T at frequency F and stays below at higher frequencies.

Curve C200 illustrates the attenuation with respect to the frequency for the electrical system 200. The values of the electrical components are: C1_{π} = C2_{π} = 10 nF, L_{π} = 0,470 mH and L_{N} is 112.7 µH. Therefore, the value of inductance L_{π} has been lowered with respect to electrical system 100. However, curve C200 comprises an attenuation notch N around notch resonant frequency F_{N}, which is chosen very close to frequency F, for example between 5% of frequency F. Thanks to this attenuation notch N, curve C200 still passes below threshold T at frequency F and stays below at higher frequencies, despite the lowered inductance L_{N}.

As illustrated, inductance L_{N} cannot be further lowered because of a bump B located just after the attenuation notch N.

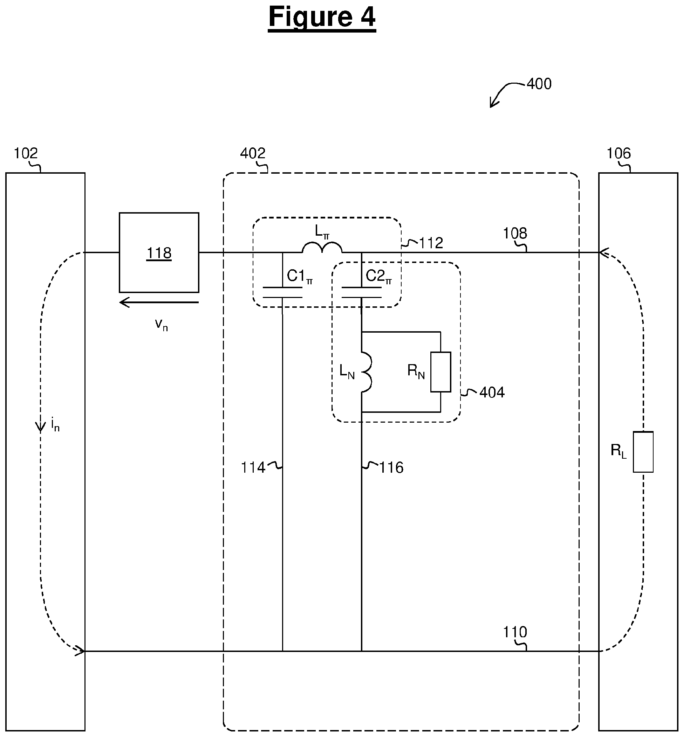

Referring to **figure 4**, an electrical system 400 according to the invention will now be described.

Electrical system 400 is similar to electrical system 200, except for the EMC filter, now referenced 402. More particularly, the notch filter, now referenced 404, further comprises a notch resistance R_{N} in parallel with inductance L_{N}. Resistance R_{N} can have any value depending on the filter.

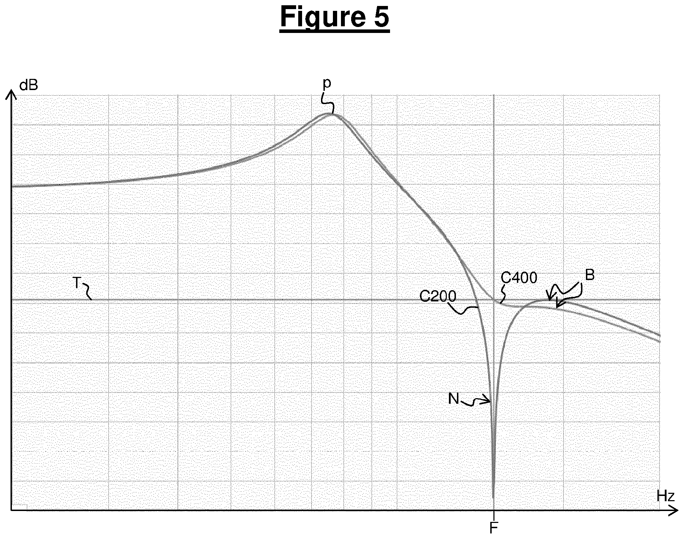

Referring to **figure 5**, curve C400 illustrates the attenuation with respect to the frequency for electrical system 400. The values of the electrical components are: C1_{π} = C2_{π} = 10 nF, L_{π} = 0,450 mH, L_{N} = 112.7 µH and R_{D} = 400 Ω. The value of inductance L_{π} has therefore been further lowered with respect to electrical system 200. This has been possible thanks to resistance R_{N} which dampens bump B. Curve C400 still passes below threshold T at frequency F and stays below at higher frequencies, despite the lowered inductance L_{N}.

Alternatively, the notch filter could be used to dampen the low frequency peak p of the low-pass filter.

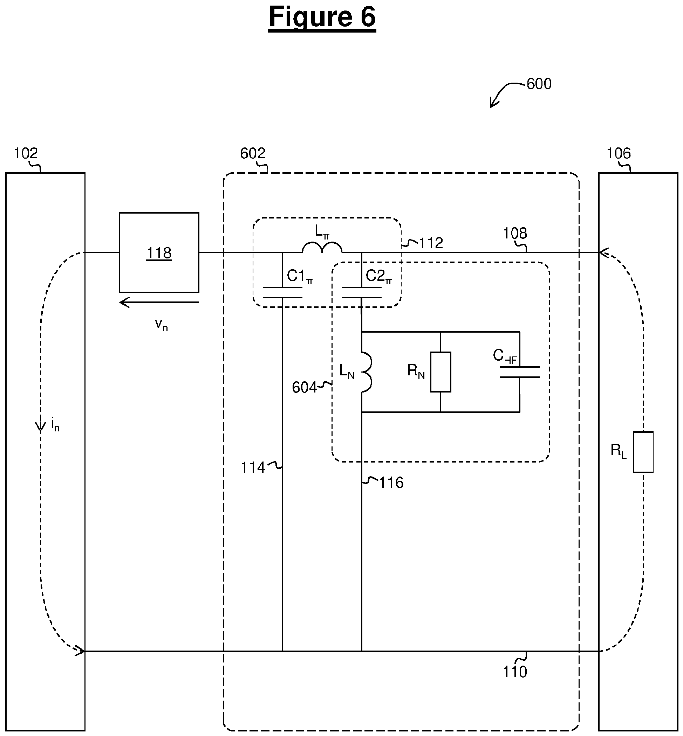

Referring to **figure 6**, another electrical system 600 according to the invention will now be described.

Electrical system 600 is similar to electrical system 400, except for the EMC filter, now referenced 602. More particularly, the notch filter, now referenced 604, further comprises a high frequency capacitance C_{HF} placed in parallel with inductance L_{N}. Capacitance C_{HF} allows improving the attenuation at high frequencies, with almost no impact around required frequency F. This will be further illustrated on the following figure.

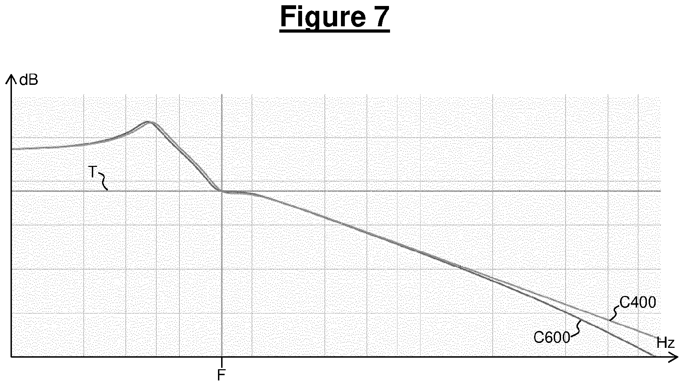

Referring to **figure 7**, curve C600 illustrates the attenuation with respect to the frequency for electrical system 600. The values of the electrical components are: C1_{π} = C2_{π} = 10 nF, L_{π} = 0,482 mH, R_{D} = 400 Ω and C_{HF} = 1 nF. The value of inductance L_{π} has therefore been slightly increased. However, in return, attenuation is improved for high frequencies. This is noticeable in the illustrated example starting from 1 MHz.

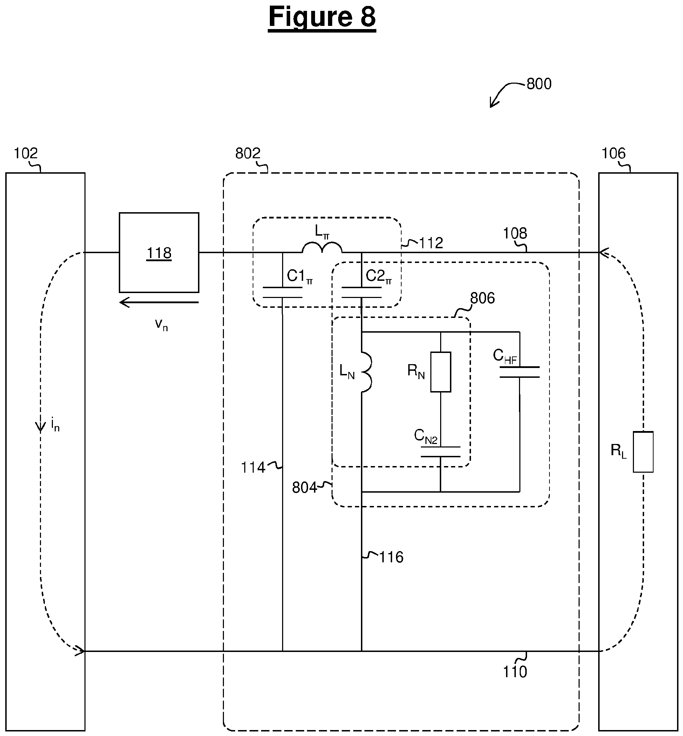

Referring to **figure 8**, another electrical system 800 according to the invention will now be described.

Electrical system 800 is similar to electrical system 600, except for the EMC filter, now referenced 802. More particularly the notch filter, now referenced 804, further comprises a capacitance C_{N2} in series with resistance R_{N}, both being in parallel with inductance L_{N}. Capacitance C_{N2} creates an auxiliary notch filter 806 with inductance L_{N}. Preferably, notch filter 806 has a resonance frequency close to resonance frequency F_{N} of notch filter 804, for example between 5% of resonance frequency F_{N}. To this end, capacitance C_{N2} is substantially equal to capacitance C2_{π}, for example between 5% of capacitance C2_{π}.

Adding capacitance C_{N2} allows to decrease inductance L_{N}. The reduction may go for example up to 50%. A smaller inductance L_{N} has the advantage to have often less resistance which means better notch behavior leading to improved performance. This will be further illustrated on the following figure. The smaller inductance L_{N} may also have a reduced size.

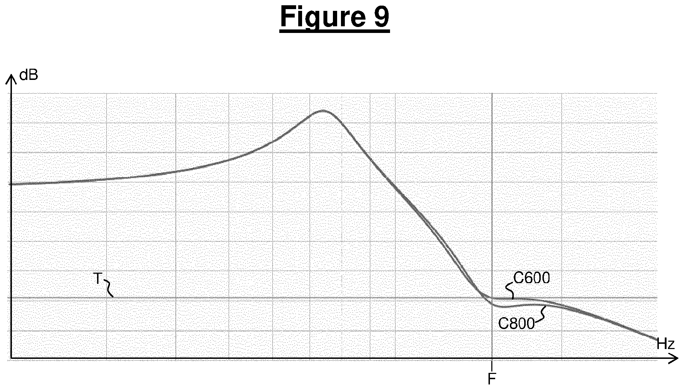

Referring to **figure 9**, curve C800 illustrates the attenuation with respect to the frequency for electrical system 800. The values of the electrical components are: C1_{π} = C2_{π} = 10 nF, L_{π} = 0,482 mH, L_{N} = 98 µH, R_{D} = 400 Ω, C_{HF} = 1 nF and C_{N2} = 10 nF. The value of inductance L_{N} has therefore been decreased. However, curve C800 still passes below threshold T at frequency F and stays below at higher frequencies, despite the lowered inductance L_{N}. There is even a distance between curve C800 and threshold T at frequency F, which can be used to further decrease inductance L_{π}.

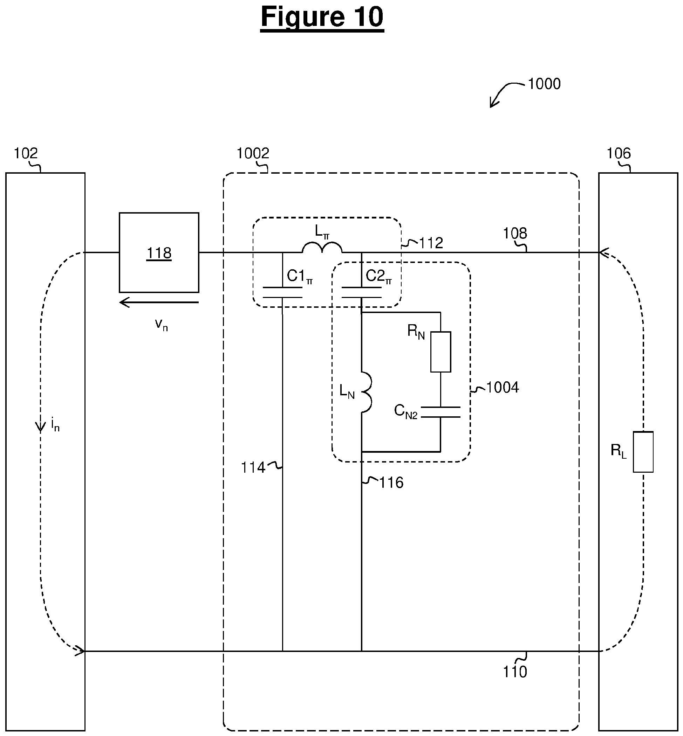

Referring to **figure 10**, another electrical system 1000 according to the invention will now be described.

Electrical system 1000 is identical to electrical system 800, except for the EMC filter, now referenced 1002, and more particularly the notch filter, now referenced 1004, which does not comprise capacitance C_{HF}. This allows to further decrease inductance L_{π}, at the expense of slightly less attenuation at high frequencies.

In other embodiments, in order to improve attenuation at high frequencies, resistance R_{N} (of figure 4, 6, 8 or 10) is preferably a frequency dependent resistance having a resistance value that decreases with frequency starting from the notch resonance frequency. For example, resistance R_{N} comprises one of the following: an inductor above complex permeability, an operational amplifier circuit with feedback like a gyrator circuit and an equivalent series resistance of capacitance C_{N} of figure 8 or 10. An inductor above complex permeability is an inductor operating at high frequency where core loss dominates the component which then is again a resistance. As frequency increases the choke turns from being an inductor to a resistor due to more and more energy is being used to change the internal inductors magnetic domains.

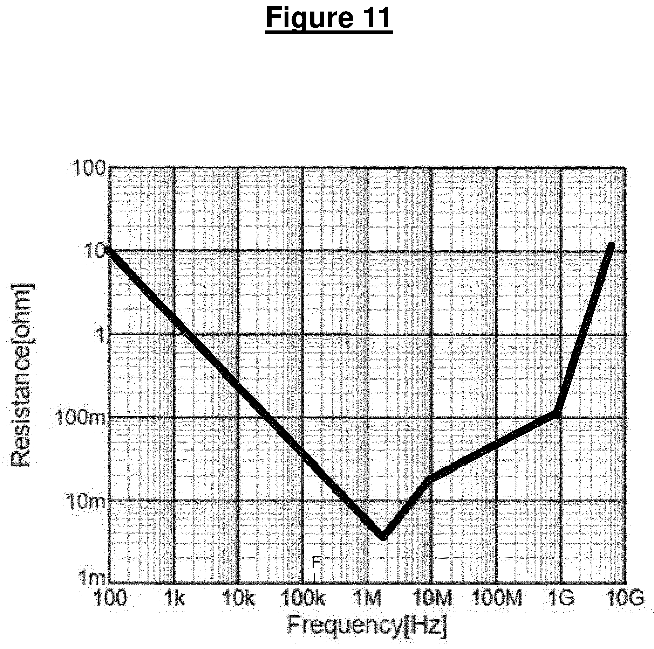

Referring to **figure 11**, an example of evolution of resistance R_{N} with respect to the frequency is illustrated. Resistance R_{N} decreases until a frequency of about 2 MHz. In particular, resistance R_{N} decreases from the notch frequency F to 2 MHz. In addition, for example, resistance R_{N} comprises a capacitor operating in the Electrical Series Resistance (ESR) area with an ESR decreasing with frequency, due for example to dielectric.

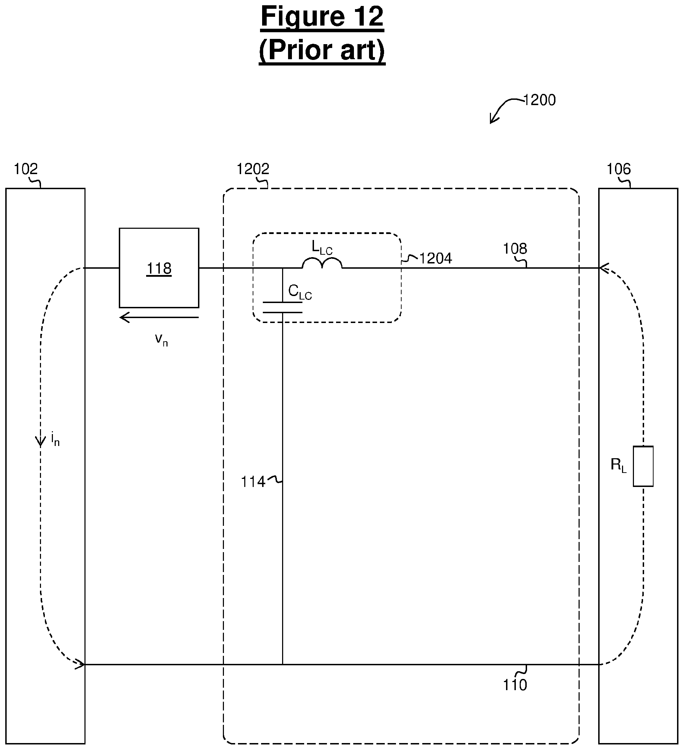

Referring to **figure 12**, an electrical system 1200 according to prior art will now be described.

Electrical system 1200 is similar to electrical system 100, except for the EMC filter, now referenced 1202. In electrical system 1200, EMC filter 1202 comprises a parallel LC filter 1204, which is a low-pass filter having a cutoff frequency F_{LP} (i.e. a low-pass resonance frequency). Parallel LC filter 1204 comprises a first shunt capacitance C_{LC} placed on shunt branch 114 and a series inductance L_{LC} placed on first power electrical branch 108, between shunt electrical branch 114 and load 106.

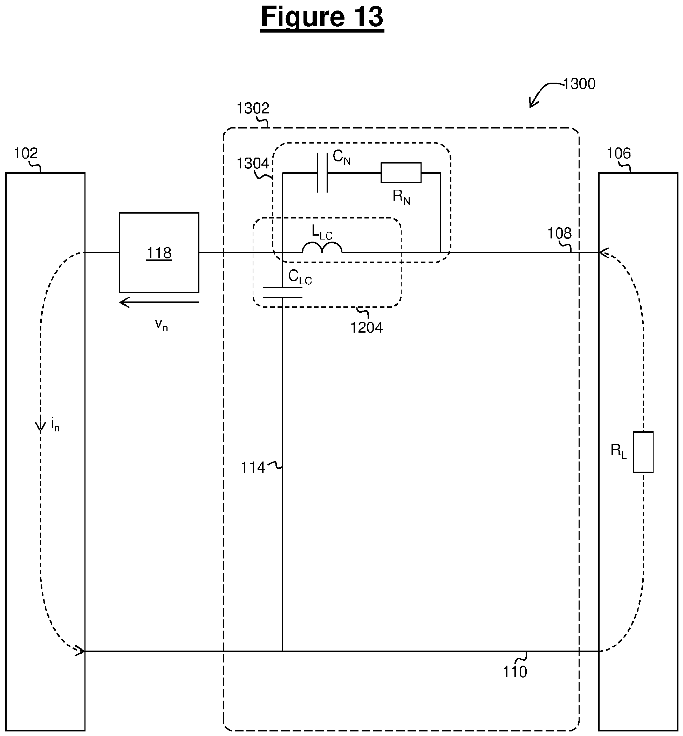

Referring to **figure 13**, another electrical system 1300 according to the invention will now be described.

Electrical system 1300 is similar to electrical system 1200 except for the EMC filter, now referenced 1302, which comprises a notch filter 1304 in addition to parallel LC filter 1204. Notch filter 1304 comprises inductance L_{LC} of parallel LC filter 1204, a notch capacitance C_{N} and a notch resistance R_{N} in series with capacitance C_{N}, both being in parallel with inductance L_{LC}.

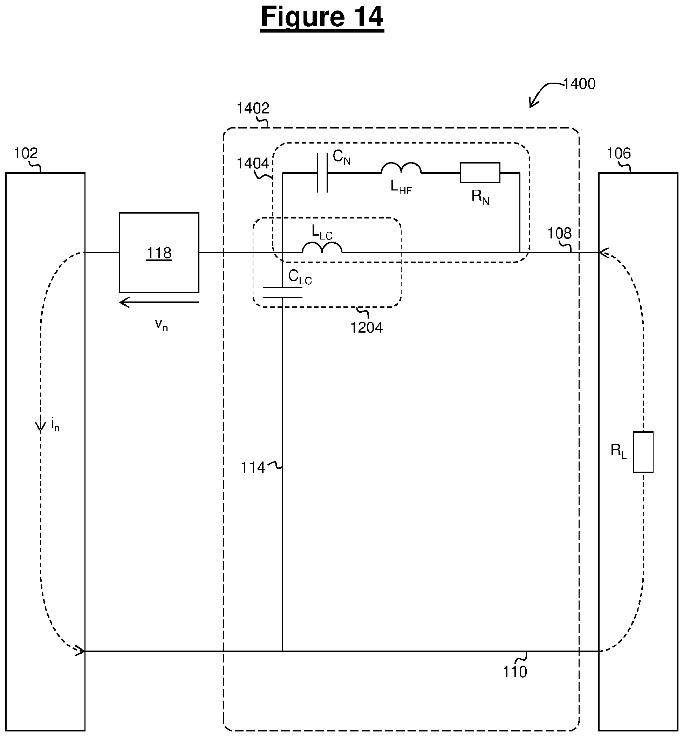

Referring to **figure 14**, another electrical system 1400 according to the invention will now be described.

Electrical system 1400 is similar to the electrical system 1300, except for the EMC filter, now referenced 1402, and more particularly the notch filter, now referenced 1404, which further comprises an inductance L_{N} in series with capacitance C_{N} and resistance R_{N}, all three being in parallel with inductance L_{LC}.

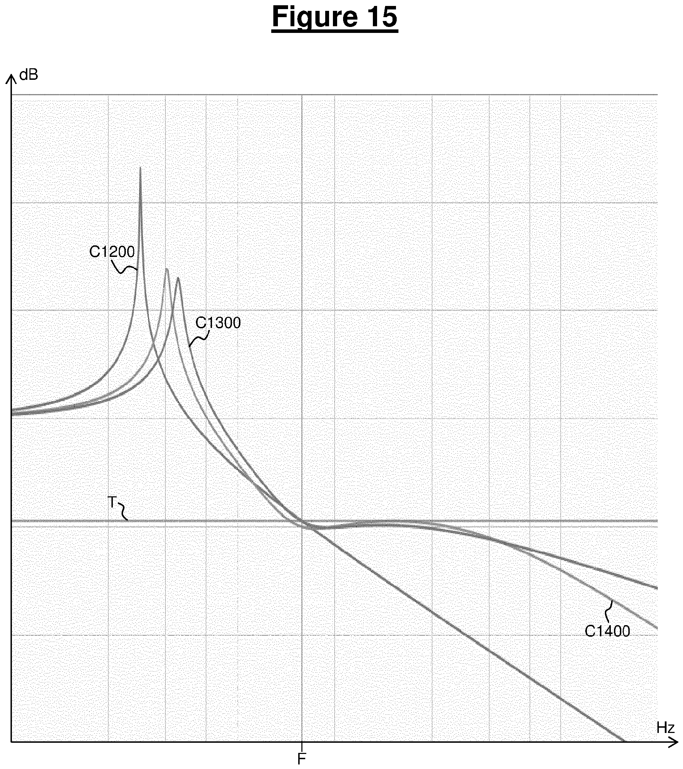

Referring to **figure 15**, curve C1200 illustrates the attenuation with respect to the frequency for electrical system 1200. The values of the electrical components for curve C1200 are: C_{LC} = 10 nF and L_{LC} = 1mH.

In this example, attenuation T is required starting from a frequency F of 160 kHz. As illustrated, curve C1200 passes below threshold T at frequency F and stays below at higher frequencies.

Curve C1300 illustrates the attenuation with respect to the frequency for the electrical system 1300. The values of the electrical components are: C_{LC} = 4.9 nF, L_{LC} = 1mH, C_{N} = 1 nF and R_{D} = 600 Ω. The value of inductance C_{LC} has therefore been lowered with respect to electrical system 1200, thanks to resistance R_{N} which allows to control the attenuation above notch resonant frequency F_{N}; similarly to what was described previously in reference to figures 1 to 11.

In order to improve attenuation at high frequencies, resistance R_{N} (of figure 13) is preferably a frequency dependent resistance having a resistance value that increases with frequency starting from the notch resonance frequency. For example, we can use the increasing resistance of an inductor in its complex permeability area.

Curve C1400 illustrates the attenuation with respect to the frequency for the electrical system 1400. The values of the electrical components are: C_{LC} = 5.9 nF, L_{LC} = 1mH, C_{N} = 1 nF, R_{D} = 600 Ω and L_{HF} = 100 µH. Adding inductance L_{HF} allows to increase the attenuation at high frequencies, at the cost of a slight increase of C_{LC}. Inductance L_{HF} can be used in addition to a frequency dependent resistance R_{N}.

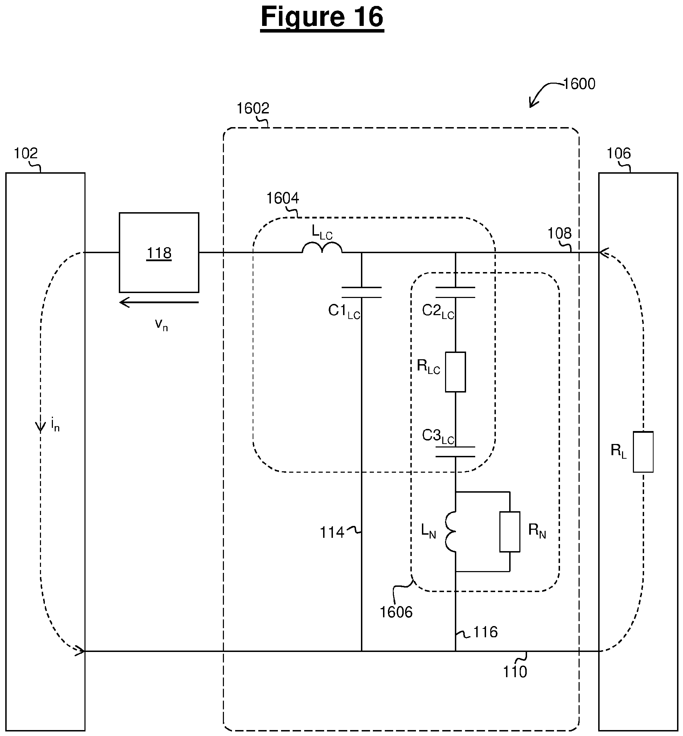

Referring to **figure 16**, another electrical system 1600 according to the invention will now be described.

In electrical system 1600, the EMC filter, now referenced 1602 first comprises a second order low-pass filter 1604 having a cutoff frequency F_{LP}. Second order low-pass filter 1604 comprises a series inductance LLC located on first power electrical branch 108, between DC power source 102 and first shunt electrical branch 114. Second order low-pass filter 1604 further comprises a first shunt capacitance C1_{LC} located on first shunt branch 114 and second and third shunt capacitances C2_{LC}, C3_{LC} located in series on second shunt branch 116. Second order low-pass filter 1604 further comprises a dampening resistance R_{LC} located on second shunt branch 116, in series with capacitances C2_{LC}, C3_{LC}.

EMC filter 1602 further comprises a notch filter 1606 having a notch resonance frequency close to cutoff frequency F_{LP}, for example between 5% of cutoff frequency F_{LP}. Notch filter 1606 comprises capacitances C2_{LC}, C3_{LC} and a notch inductance L_{N} located on second shunt branch 116, in series with capacitances C2_{LC}, C3_{LC}. Notch filter 1606 further comprises a control resistance R_{N} in parallel with inductance L_{N}.

In other examples, capacitance C2_{LC} and resistance R_{LC} could be removed.

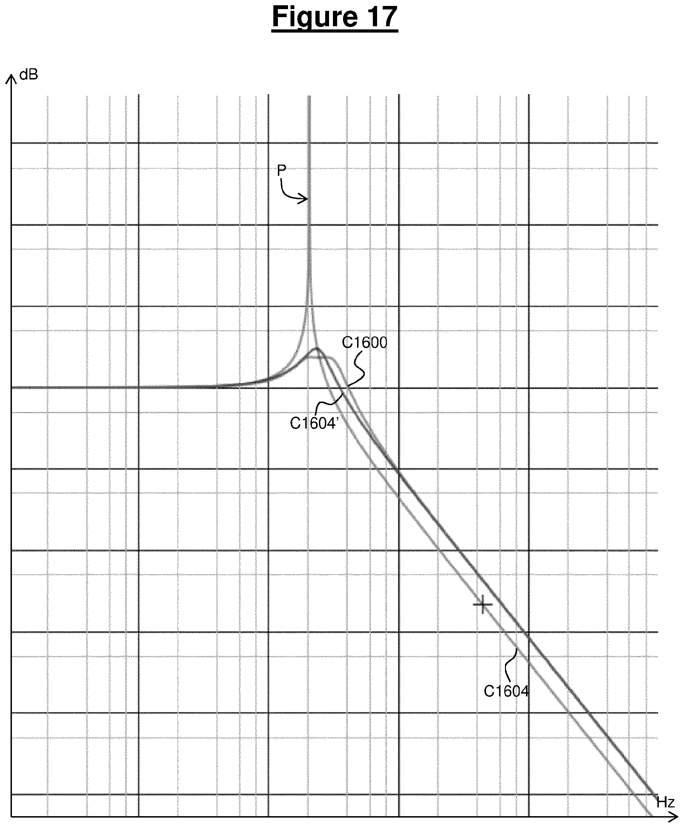

Referring to **figure 17**, curve C1604 illustrates the attenuation with respect to the frequency for the second order low-pass filter 1604 in an ideal case (i.e. of electrical system 1600 without inductance L_{N} and resistance R_{N}, and with R_{LC} = 0 Ω). The values of the electrical components are: L_{LC} = 300 nH, C1_{LC} = 1 µF, and C2_{LC} = C3_{LC} = 2 µF. As illustrated, curve C1604 comprises a peak P at cutoff frequency F_{LP}.

Curve C1604' illustrates the attenuation with respect to the frequency for the second order low-pass filter 1604 for resistance R_{LC} = 860 mΩ. As illustrated, peak P is dampened thanks to resistance R_{LC}.

Curve C1600 illustrates the attenuation with respect to the frequency for the electrical system 1600. The values of the electrical components are: L_{LC} = 300 nH, C1_{LC} = 1 µF, C2_{LC} = C3_{LC} = 1 µF, R_{LC} = 500mΩ, L_{N} = 900n and R_{N} = 225 Ω. Adding inductance L_{N} and resistance R_{N} therefore allows to reduce capacitance C2_{LC}, C3_{LC} and resistance R_{LC}. In fact, because notch resonance frequency F_{N} is close to cutoff frequency F_{LP}, the attenuation notch of notch filter 1606 compensates at least in part peak P of second order low-pass filter 1604, so as to dampen peak P.

It is clear that a notch filter like the ones described above allows to control the attenuation above the notch resonance frequency.

The invention is not limited to the embodiments described above. It will appear to those skilled in the art that various modifications can be made to the embodiments described above, in the light of the teaching which has just been disclosed to them.

In particular, although the described examples use a DC power source, the invention could be used for AC power source, for example between each of the three lines of a three-phase system and the ground.

The invention could also be used in low power systems.

In the detailed presentation of the invention which has been made previously, the terms used should not be interpreted as limiting the invention to the embodiments set out in this description, but must be interpreted to include all the equivalents the prediction of which is within the reach of the skilled person by applying their general knowledge to the implementation of the teaching which has just been disclosed to them.

## Claims

1. Notch filter (404; 604; 804; 1004; 1304; 1404; 1606; 1800; 2000) comprising a notch inductance (L_{N}; L_{LC}) and a notch capacitance (C2_{π}; CN; C2_{LC}, C3_{LC}) defining a notch resonance frequency, **characterized in that** it further comprises an attenuation control resistance (R_{N}) in parallel with the notch inductance (L_{N}) if the notch inductance (L_{N}) and the notch capacitance (C2_{π}; C2_{LC}, C3_{LC}) are in series or in series with the notch capacitance (C_{N}) if the notch inductance (L_{LC}) and the notch capacitance (C_{N}) are in parallel.

2. Notch filter (404; 604; 804; 1004; 1304; 1404) according to claim 1, wherein the notch resistance (R_{N}) is a frequency dependent resistance.

3. Notch filter (404; 604; 804; 1004; 1606; 1800) according to claim 1 or 2, wherein the notch inductance (L_{N}) and the notch capacitance (C2_{π}; C2_{LC}, C3_{LC}) are in series, and wherein the attenuation control resistance (R_{N}) is in parallel with the notch inductance (L_{N}).

4. Notch filter according to claim 3, wherein the attenuation control resistance has a resistance value that decreases with frequency starting from the notch frequency.

5. Notch filter (604; 804) according to claim 3 or 4, further comprising a capacitance (C_{HF}) in parallel with the notch inductance (L_{N}) and the attenuation control resistance (R_{N}).

6. Notch filter (804; 1004) according to any of claims 3 to 5, further comprising a capacitance (CN2) in series with the attenuation control resistance (R_{N}).

7. Notch filter (1304; 1404; 2000) according to claim 1 or 2, wherein the notch inductance (L_{LC}) and the notch capacitance (C_{N}) are in parallel, and wherein the attenuation control resistance (R_{N}) is in series with the notch capacitance (C_{N}).

8. Notch filter (1304) according to claim 7, wherein the attenuation control resistance has a resistance value that increases with frequency starting from the notch frequency.

9. Notch filter (1404) according to claim 7 or 8, further comprising an inductance (L_{HF}) in series with the notch capacitance (C_{N}) and the attenuation control resistance (R_{N}).

10. Notch filter (1404) according to claim 2 and any of claims 7 to 9, wherein the attenuation control resistance (R_{N}) has a resistance value that increases with frequency until at least a frequency greater than the notch resonance frequency.

11. Filter (402; 602; 802; 1002; 1302; 1402; 1602) comprising:
- a low-pass filter (112; 1204; 1604); and
- a notch filter (404; 604; 804; 1004; 1304; 1404; 1606) according to any of claims 1 to 10, wherein one amongst the notch inductance and the notch capacitance is also part of the low-pass filter.

12. Electrical system (400; 600; 800; 1000; 1300; 1400; 1600) comprising:
- a power source (102);
- a load (106); and
- a notch filter (404; 604; 804; 1004; 1304; 1404; 1606) according to any of claims 1 to 10 or a filter (402; 602; 802; 1002; 1302; 1402; 1602) according to claim 11, through which the load (106) is connected to the power source (102).
